# EUROPÄISCHE PATENTSCHRIFT

(11) **EP 3 853 621 B1**
(45) Veröffentlichungstag und Bekanntmachung des Hinweises auf die Patenterteilung: **13.09.2023**
(21) Anmeldenummer: 19780170.7
(22) Anmeldetag: 19.09.2019
(51) Int. Cl.: G01R 15/20, H01F 3/14

(54) **FORMTEIL ZUR AUFNAHME EINES C-FÖRMIGEN MAGNETFELDKONZENTRATIONSELEMENTS, MAGNETFELDKONZENTRATIONSVORRICHTUNG UND STROMRICHTER**
MOULDED PART FOR HOLDING A C-SHAPED MAGNETIC FIELD CONCENTRATION ELEMENT, MAGNETIC FIELD CONCENTRATION DEVICE, AND CONVERTER
PIÈCE MOULÉE DESTINÉE À RECEVOIR UN ÉLÉMENT DE CONCENTRATION DE CHAMP MAGNÉTIQUE EN FORME DE C, DISPOSITIF DE CONCENTRATION DE CHAMP MAGNÉTIQUE ET CONVERTISSEUR DE PUISSANCE

(30) Priorität: 20.09.2018 DE 102018123204
(43) Veröffentlichungstag der Anmeldung: 28.07.2021
(73) Patentinhaber: Valeo eAutomotive Germany GmbH, 91056 Erlangen (DE)
(72) Erfinder: PFEIFFER, Kay, 91058 Erlangen (DE)
(86) Internationale Anmeldenummer: PCT/EP2019/075184
(87) Internationale Veröffentlichungsnummer: WO 2020/058410

(56) Entgegenhaltungen:
- US-A1- 2008 284 410
- US-A1- 2009 128 129
- US-A1- 2010 001 715
- US-A1- 2012 268 106
- US-A1- 2014 167 750

## Beschreibung

Die vorliegende Erfindung betrifft einen Stromrichter.

Die US 2014/167750 A1 offenbart einen Stromsensor, umfassend einen oberen magnetischen Kern, einen unteren magnetischen Kern, ein erstes zentrales Gehäuse und ein zweites zentrales Gehäuse. Das erste zentrale Gehäuse haust unteren magnetischen Kern ein. Das zweite zentrale Gehäuse haust den oberen magnetischen Kern ein. Die zentralen Gehäuse sind Gleichteile und durch einen Eingriffsabschnitt miteinander in Eingriff gebracht. Durch die zentralen Gehäuse wird ein Rahmenkörper ausgebildet, der die Positionen der magnetischen Kerne zueinander fixiert. Die magnetischen Kerne sind rechteckig geformt. Der Stromsensor umfasst ferner ein Hallelement zum Detektieren eines Magnetfelds.

Die US 2010/001715 A1 offenbart einen Stromsensor mit einem äußeren Körper und einem weichmagnetischen Körper, der innerhalb des äußeren Körper angeordnet und ein erstes und zweites Kernelement aufweist. Zwischen den Kernelementen ist ein Lumen ausgebildet, das zum Aufnehmen eines Leiters eingerichtet ist. Es ist ferner ein magnetischer Felddetektor zum Erfassen eines Stroms im Leiter vorgesehen. Der Felddetektor weist zumindest einen Abschnitt, der zwischen den Kernelementen anordnet ist, auf.

Die US 2012/268106 A1 offenbart ein Stromüberwachungsgerät mit einem Gehäuse, das zwei Abschnitte aufweist, die aneinander befestigbar sind.

Das Dokument DE 10 2014 112 299 A1 offenbart einen Sensor mit einer Stromleitung, welcher dazu ausgestaltet ist, eine Stromstärke eines durch die Stromleitung fließenden Stroms zu messen, wobei der Sensor ein magnetsensitives Element und einen magnetischen Kern, der die Stromleitung zumindest teilweise umschließt und der zwei Spalte aufweist, umfasst, wobei das magnetsensitive Element in dem ersten Spalt des magnetischen Kerns angeordnet ist.

Ein solcher Sensor realisiert eine berührungslose Strommessung, wobei der magnetische Kern in zwei C-förmige Magnetfeldkonzentrationselemente, welche jeweils zwei Schenkel und einen die Schenkel verbindenden Steg aufweisen, aufgeteilt ist. Insbesondere bei beschränken bzw. beengten Montageraumverhältnissen ist die Anordnung der Magnetfeldkonzentrationselemente an der Stromschiene schwierig.

Der Erfindung liegt die Aufgabe zugrunde, eine raumsparende Möglichkeit zur Montage C-förmiger Magnetfeldkonzentrationselemente anzugeben.

Zur Lösung dieser Aufgabe wird erfindungsgemäß ein Stromrichter gemäß Anspruch 1 vorgeschlagen. Vorteilhafte Ausgestaltungen sind Gegenstand der abhängigen Ansprüche.

Die Erfindung beruht auf der Überlegung, das C-förmige Magnetfeldkonzentrationselement in ein Formteil aufzunehmen, welches sowohl den Steg als auch die Schenkel zumindest abschnittsweise einhaust, so dass das Magnetfeldkonzentrationselement in einem im Formteil aufgenommenen Zustand sicher, beispielsweise bezüglich einer Stromschiene, positionierbar ist. Um ein weiteres C-förmiges Magnetfeldkonzentrationselement zum Schließen eines magnetischen Kreises zuverlässig bezüglich des Formteils positionieren zu können, wird vorgeschlagen, das Positionierelement vorzusehen, durch welches die Formteile zueinander positioniert werden können.

Das Formteil weist eine Reihe von Vorteilen gegenüber herkömmlichen Möglichkeiten zur Aufnahme von - nicht notwendigerweise C-förmigen - Magnetfeldkonzentrationselementen auf. Während es bereits vorgeschlagen wurde, Magnetfeldkonzentrationselemente in einem Paket anzuordnen und zu umspritzen, erlaubt es das Formteil, die Magnetfeldkonzentrationselemente von beiden Seiten auf die Stromschiene aufzusetzen und dank des Positionierelements in einer vorgegebenen Relativposition zueinander anzuordnen. Dies erlaubt eine Montage der Magnetfeldkonzentrationselemente auch auf kleinstem und/oder beengten Bauraum. Zudem ermöglicht das Formteil eine Erhöhung der Fertigungstiefe, da die Formteile mitsamt den Magnetfeldkonzentrationselementen bei der Endmontage eines Geräts, beispielsweise eines Stromrichters, oder einer Vorbaugruppe angeordnet werden kann. So wird eine besonders raumsparende Möglichkeit zur Anordnung C-förmiger Magnetfeldkonzentrationselemente realisiert.

Das Formteil ist typischerweise aus einem Kunststoff, beispielsweise durch ein Spritzgussverfahren, gebildet. Typischerweise bildet das Formteil einen die Kavität umgebenden prismenförmigen Körper mit zwei Grundflächen, die parallel zueinander angeordnet sind und die Grundflächen senkrecht verbindenden Mantelflächen aus. Dabei weisen die Grundflächen selbst im Wesentlichen eine C-Form auf. Die Schenkelaufnahmeräume schließen zweckmäßigerweise winklig, insbesondere rechtwinklig, an den Stegaufnahmeraum an. Das Positionierelement ist typischerweise dazu eingerichtet, im montierten Zustand eine Relativbewegung der Formteile zueinander in wenigstens zwei Raumrichtungen zu hemmen. Typischerweise weist das Positionierelement eine Hülse oder einen Stift auf.

Es wird bei dem Formteil bevorzugt, wenn der Stegaufnahmeraum auf seiner den Schenkelaufnahmeräumen abgewandten Seite zum Einführen des Magnetfeldkonzentrationselements geöffnet ist. Mit anderen Worten weist das Formteil eine Öffnung auf, durch welche das Magnetfeldkonzentrationselement mit seinen Schenkeln voran in die Kavität einführbar ist. Dies ermöglicht ein besonders aufwandsarmes Anordnen des Magnetfeldkonzentrationselements im Formteil.

Bevorzugt ist der erste Schenkelaufnahmeraum auf seiner dem Stegaufnahmeraum abgewandten Seite geöffnet. Dies verhindert, dass ein Spalt zwischen Endflächen der Schenkel der Magnetfeldkonzentrationselemente im montierten Zustand, der beispielsweise für die Anordnung eines Magnetfeldsensors vorgesehen sein kann, durch das Material des Formteils gefüllt ist. Zweckmäßigerweise ist durch die Öffnung eine Ausnehmung des Formteils ausgebildet, welche ein Herausragen des Magnetfeldkonzentrationselements aus dem Formteil erlaubt.

Ferner kann das Formteil auf der dem zweiten Schenkelaufnahmeraum zugewandten Seite des ersten Schenkelaufnahmeraums einen Vorsprung aufweist. Der Vorsprung stützt insbesondere das herausragende Magnetfeldkonzentrationselement ab.

Es kann bei dem Formteil ferner vorgesehen sein, dass der zweite Schenkelaufnahmeraum auf seiner dem Stegaufnahmeraum abgewandten Seite geschlossen ist. Das Formteil weist mithin eine das freie Ende des in den zweiten Schenkelaufnahmeraum aufnehmbaren oder aufgenommenen Schenkels abdeckende Mantelfläche auf. Die so ausgebildete Mantelfläche des Formteils kann auf einer entsprechenden Mantelfläche des anderen Formteils aufliegen. Dies ermöglicht eine besonders stabile Positionierung der Formteile zueinander und verhindert ein Eindringen von Fremdkörpern in einen zweiten Spalt des magnetischen Kreises.

Bei dem Formteil kann mit Vorteil ein zum ersten Positionierelement gegengleich ausgebildetes zweites Positionierelement vorgesehen sein. Im montierten Zustand korrespondiert mithin das erste Positionierelement des Formteils mit dem gegengleichen zweiten Positionierelement des weiteren Formteils und umgekehrt. So können für die Positionierung der Magnetfeldkonzentrationselemente Gleichteile zum Einsatz kommen, was den Bauteilaufwand und damit die Teilekosten endlich reduziert. Zweckmäßigerweise sind die Positionierelemente an gegenüberliegenden Grundflächen angeordnet.

Optional kann bei dem Formteil vorgesehen sein, dass ein Positionierelement einen Befestigungsmechanismus zum Befestigen des anderen Formteils aufweist. Alternativ oder zusätzlich kann vorgesehen sein, dass das Formteil einen Befestigungsmechanismus zum Befestigen des Magnetfeldkonzentrationselements in der Kavität aufweist. Ein jeweiliger Befestigungsmechanismus kann beispielsweise ein Rastmechanismus sein. Es ist jedoch auch möglich, dass die Formteile miteinander verklebt sind bzw. das Magnetfeldkonzentrationselement mit dem Formteil verklebt ist.

Erfindungsgemäß umfasst das Formteil ein weiteres Positionierelement, das au-ßen an einer die Kavität begrenzenden Mantelfläche des Formteils angeordnet ist. Besonders bevorzugt ist das weitere Positionierelement an der den ersten Schenkelaufnahmeraum begrenzenden Mantelfläche angeordnet. Das weitere Positionierelement ist bevorzugt stiftförmig, insbesondere mit einem sich verjüngenden freien Ende ausgebildet. Mittels des weiteren Positionierelements kann das Formteil in vorteilhafter Weise an einer übergeordneten Baugruppe, beispielsweise einer Leiterplatte, positioniert und ggf. auch befestigt werden.

Die Magnetfeldkonzentrationselemente sind bevorzugt aus Stapeln von Einzelblechen gebildet. Die Einzelbleche weisen bevorzugt jeweils die C-Form auf. Der Durchführungsraum hat typischerweise einen rechteckigen oder abgerundet rechteckigen Querschnitt.

Es wird dabei bevorzugt, wenn die Magnetfeldkonzentrationselemente in den Formteilen und/oder die Positionierelemente miteinander verklebt sind. So kann auch ohne zusätzliche Befestigungsmechanismen eine sichere Anordnung der Magnetfeldkonzentrationselemente zueinander realisiert werden. Dies vereinfacht die Fertigung der Formteile.

Typischerweise sind drei Magnetfeldkonzentrationsvorrichtungen, durch deren Durchführungsraum jeweils eine Stromschiene geführt ist und denen jeweils ein Magnetfeldsensor zugeordnet ist, vorgesehen.

Erfindungsgemäß umfasst der Stromrichter eine Leiterplatte, welche elektrisch leitend mit den Magnetfeldsensoren verbunden ist und ein Positionierelement aufweist, durch welches das weitere Positionierelement eines jeweiligen Formteils an der Leiterplatte anordenbar ist. Außerdem kann vorgesehen sein, dass auf der der Magnetfeldkonzentrationsvorrichtung gegenüberliegenden Seite der Leiterplatte wenigstens ein Befestigungsmittel zum Befestigen wenigstens eines der weiteren Positionierelemente vorgesehen ist.

Wegen der besonders einfachen Montierbarkeit der in die Formteile aufgenommenen Magnetfeldkonzentrationselemente kann eine Stromschiene unmittelbar vor und/oder hinter ihrer Durchführung durch den Durchführungsraum einen in einer Ebene gekrümmten Verlauf aufweisen. So lassen sich auch komplex geformte Stromschienen aufwandsarm mit Magnetfeldkonzentrationsvorrichtungen ausrüsten.

Sämtliche Ausführungen zum Formteil lassen sich analog auf die Magnetfeldkonzentrationsvorrichtung und den erfindungsgemäßen Stromrichter übertragen, so dass auch mit diesem die zuvor genannten Vorteile realisiert werden können.

Weitere Vorteile und Einzelheiten der vorliegenden Erfindung ergeben sich aus den im folgenden beschriebenen Ausführungsbeispielen sowie anhand der Zeichnungen. Diese sind schematische Darstellungen und zeigen:
- Fig. 1: eine perspektivische Darstellung eines Formteils mit Magnetfeldkonzentrationselementen;
- Fig. 2: eine Seitenansicht auf eine Grundfläche des in Fig. 1 gezeigten Formteils;
- Fig. 3: eine Seitenansicht auf stirnseitige Mantelflächen des in Fig. 1 gezeigten Formteils;
- Fig. 4: eine Seitenansicht in eine Kavität des in Fig. 1 gezeigten Formteils;
- Fig. 5: eine Seitenansicht einer Magnetfeldkonzentrationsvorrichtung;
- Fig. 6: eine teilweise Seitenansicht eines Ausführungsbeispiels des erfindungsgemäßen Stromrichters; und
- Fig. 7: eine teilweise perspektivische Darstellung des in Fig. 6 gezeigten Stromrichters

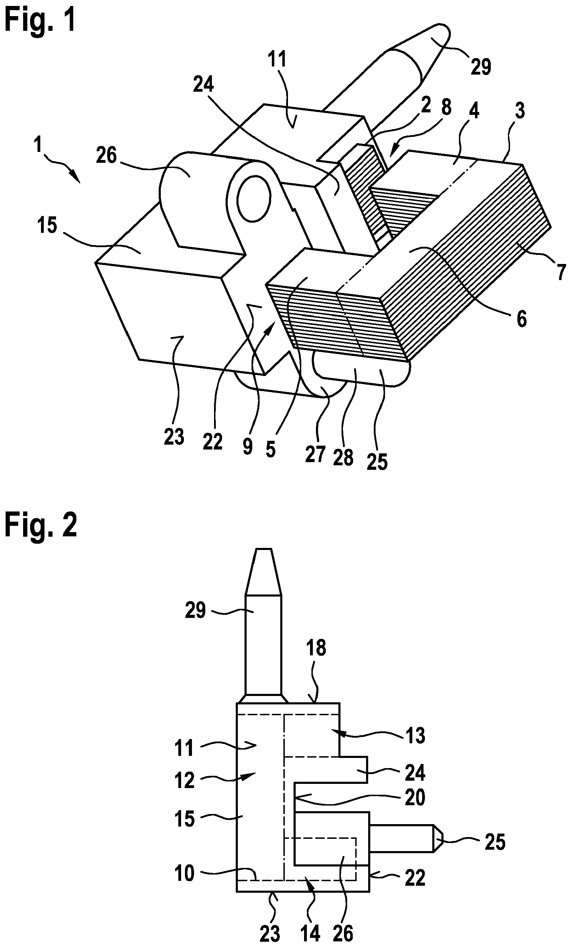

Fig. 1 ist eine perspektivische Darstellung eines Formteils 1 zur Aufnahme eines C-förmigen Magnetfeldkonzentrationselements 2. Daneben ist ein weiteres Magnetfeldkonzentrationselements 3, welches identisch zum Magnetfeldkonzentrationselement 2 ausgebildet und bezüglich dieses spiegelsymmetrisch angeordnet ist, gezeigt.

Ersichtlich weist jedes Magnetfeldkonzentrationselement einen ersten Schenkel 4, einen zweiten Schenkel 5, und einen die Schenkel 4, 5 verbindenden Steg 6 auf. Die Schenkel 4, 5 stehen dabei rechtwinklig vom Steg 6 ab und sind in dem gezeigten Beispiel kürzer als der Steg 6. Die Grenzen zwischen den Schenkeln 4, 5 und dem Steg 6 sind in Fig. 1 durch strichpunktierte Linien gekennzeichnet. Die Magnetfeldkonzentrationselemente 2, 3 ist aus einer Vielzahl gestapelter, C-förmiger, weichmagnetischer Einzelbleche 7 gebildet. In der in Fig. 1 gezeigten Darstellung bilden die Magnetfeldkonzentrationselemente 2, 3 einen zwei Spalte 8, 9 aufweisenden magnetischen Kreis aus.

Die Fig. 2 bis 4 sind verschiedene Seitenansichten des Formteils 1, wobei Fig. 2 eine Seitenansicht auf eine Grundfläche 11 ist.

Das Formteil 1 weist eine Kavität 10 zum Aufnehmen des Magnetfeldkonzentrationselements 2 auf, wobei durch gestrichelte Linien die Lage der Kavität 10 innerhalb des Formteils 1 kenntlich gemacht ist. Die Kavität 10 umfasst ein zum Aufnehmen des Stegs 6 des Magnetfeldkonzentrationselements 2 ausgebildeten Stegaufnahmeraum 12, einen ersten Schenkelaufnahmeraum 13 zum Aufnehmen des ersten Schenkels 4 des Magnetfeldkonzentrationselements 2 und einen zweiten Schenkelaufnahmeraum 14 zum Aufnehmen des zweiten Schenkels 5 des Magnetfeldkonzentrationselements 2. Die Grenzen zwischen dem Stegaufnahmeraum 12 bzw. den Schenkelaufnahmeräumen 13, 14 ist durch strichpunktierte Linien dargestellt.

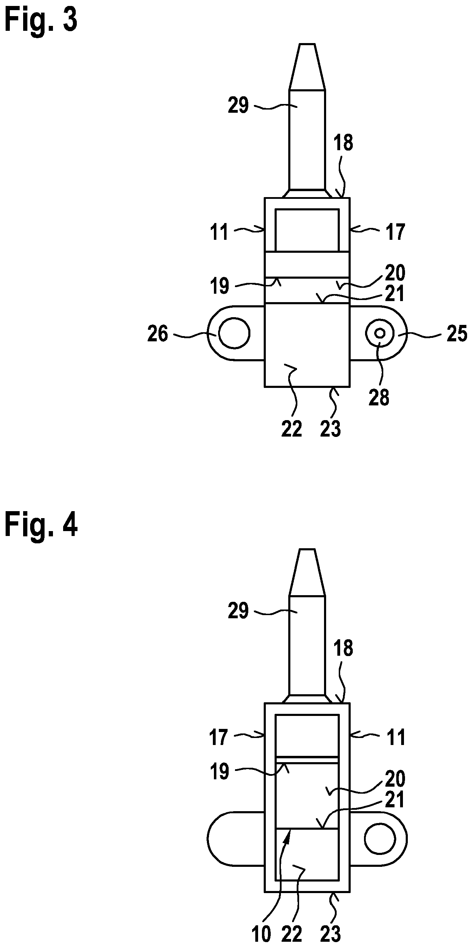

Das Formteil 1 umfasst einen prismenförmigen Körper 15, in dem die Kavität 10 ausgebildet ist. Dabei liegt der Grundfläche 11 eine gleichartig ausgebildete zweite Grundfläche 17 (siehe Fig. 3 und 4) parallel gegenüber. Die Grundflächen 11, 17 begrenzen sowohl den Stegaufnahmeraum 12 als auch die Schenkelaufnahmeräume 13, 14.

Der erste Schenkelaufnahmeraum 13 ist im Übrigen durch eine äußere Mantelfläche 18, und eine innere Mantelfläche 19 begrenzt. Der Stegaufnahmeraum 12 ist ferner durch eine stirnseitige Mantelflächen 20 begrenzt. Der zweite Schenkelaufnahmeraum 14 ist ferner durch eine innere Mantelfläche 21, eine stirnseitige Mantelfläche 22 und eine äußere Mantelfläche 23 begrenzt. Dabei begrenzen die äu-ßeren Mantelflächen 18, 23 und die stirnseitige Mantelfläche 20 auch den Stegaufnahmeraum 12. Wie insbesondere aus Fig. 3, die eine Seitenansicht des Formteils 1 auf Außenseiten der stirnseitigen Mantelflächen 20, 23 ist, und Fig. 4, die eine Seitenansicht des Formteils 1 in die Kavität 10 ist, weisen die inneren Mantelflächen 19, 21 eine höhere Materialstärke als die äußeren Mantelflächen 18, 23, die stirnseitigen Mantelflächen 20, 22 und die Grundflächen 11, 17 auf.

Der Stegaufnahmeraum 12 ist auf seiner den Schenkelaufnahmeräumen 13, 14 gegenüberliegenden Seite zum Einführen des Magnetfeldkonzentrationselements 2 geöffnet. Das heißt, dass eine erste Öffnung des Körpers 15 durch die Grundflächen 11, 17 und die äußeren Mantelflächen 18, 23 berandet ist. Daneben ist der erste Schenkelaufnahmeraum 13 auf seiner dem Stegaufnahmeraum gegenüberliegenden Seite geöffnet, so dass - wie in Fig. 1 gezeigt - der erste Schenkel 4 des Magnetfeldkonzentrationselements 2 aus einer zweiten Öffnung des Körpers 15 hervorragen kann. Die zweite Öffnung wird mithin durch die Grundflächen 11, 17, die äußere Mantelfläche 18 und die innere Mantelfläche 19 berandet. Außerdem weist das Formteil 1 auf der dem zweiten Schenkelaufnahmeraum 14 zugewandten Seite des ersten Schenkelaufnahmeraums 13 einen Vorsprung 24 auf, welcher als vom Körper 15 hervorragende stirnseitige Verlängerung der inneren Mantelfläche 19 ausgebildet ist.

Des Weiteren umfasst das Formteil 1 ein erstes Positionierelement 25 und ein zweites Positionierelement 26, durch welches ein weiteres Formteil spiegelsymmetrisch bezüglich des Formteils 1 positionierbar ist. Das erste Positionierelement 25 weist einen Trägerabschnitt 27, welcher an einer Außenseite der Grundfläche 17 angeordnet ist und einen davon auf Höhe der stirnseitigen Mantelfläche 22 abstehenden Stiftabschnitt 28 auf. Das zweite Positionierelement 26 ist hülsenartig ausgebildet und an einer Außenseite der Grundfläche 11 angeordnet. Das zweite Positionierelement 26 schließt im Wesentlichen bündig mit der stirnseitigen Mantelfläche 22 ab. Die Positionierelemente 25, 26 sind folglich gegengleich ausgebildet, so dass der Stiftabschnitt 28 des ersten Positionierelement 25 in das hülsenartige zweite Positionierelement 26 des weiteren Formteils einführbar ist und umgekehrt.

Darüber hinaus umfasst das Formteil 1 ein drittes Positionierelement 29, welches an einer Außenseite der äußeren Mantelfläche 18 angeordnet ist. Das dritte Positionierelement 29 ist stiftartig ausgebildet und verjüngt sich zu seinem freien Ende hin. Das dritte Positionierelement 29 ist näher an der stegaufnahmeraumseitigen Öffnung angeordnet als an der schenkelaufnahmeraumseitigen Öffnung.

Gemäß einem weiteren, nicht gezeigten Beispiel eines Formteils, weist dieses einen Befestigungsmechanismus zum Befestigen des Magnetfeldkonzentrationselements in der Kavität auf. Alternativ oder zusätzlich weisen das erste und das zweite Positionierelement einen Befestigungsmechanismus zum Befestigen des anderen Formteils auf. Die Befestigungsmechanismen sind Rastmechanismen.

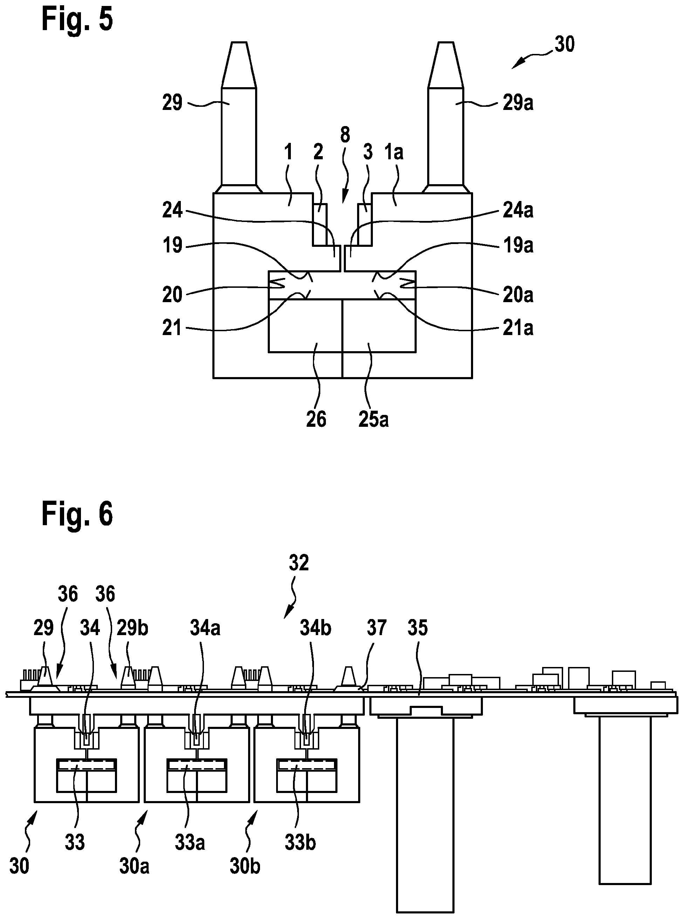

Fig. 5 ist eine Seitenansicht einer Magnetfeldkonzentrationsvorrichtung 30, welche ein in einem ersten Formteil 1 aufgenommenes erstes C-förmiges Magnetfeldkonzentrationselement 2 sowie ein in einem zweiten Formteil 1a aufgenommenes zweites C-förmiges Magnetfeldkonzentrationselement 3 aufweist.

Die Formteile 1, 1a entsprechen jeweils einem der zuvor beschriebenen Beispiele. Die Formteile 1, 1a sind durch ihre Positionierelemente 25, 26 einerseits und 25a, 26a andererseits derart zueinander angeordnet, dass die inneren und stirnseitigen Mantelflächen 19, 20, 21 bzw. 19a, 20a, 21a einen Durchführungsraum 31 für eine Stromschiene teilweise umschließen. Dabei wird der Durchführungsraum 31 durch die Vorsprünge 24, 24a zusätzlich begrenzt. Ersichtlich ist zwischen den Magnetfeldkonzentrationselementen 2, 3 der erste Spalt 8 ausgebildet, wohingegen der zweite Spalt 9 (siehe Fig. 1) in Fig. 5 durch die Formteile 1, 1a verdeckt ist.

Die Magnetfeldkonzentrationselemente 2, 3 sind im jeweiligen Formteil 1, 1a verklebt. Ebenso sind die Positionierelemente 25, 26a bzw. 26, 25a miteinander verklebt.

Fig. 6 ist eine teilweise Seitenansicht eines Ausführungsbeispiels eines Stromrichters 32, der drei Magnetfeldkonzentrationsvorrichtungen 30, 30a, 30b gemäß dem in Fig. 5 gezeigten Beispiel umfasst. Durch ein jeweiligen Durchführungsraum 31 der Magnetfeldkonzentrationsvorrichtungen 30, 30a, 30b ist eine Stromschiene 33, 33a, 33b geführt. Daneben weist der Stromrichter 32 für jede Magnetfeldkonzentrationsvorrichtung einen Magnetfeldsensor 34, 34a, 34b auf, der innerhalb des ersten Spalts 8 einer Magnetfeldkonzentrationsvorrichtung 30, 30a, 30b angeordnet ist, so dass der Stromrichter 32 dazu eingerichtet ist, basierend auf dem Hall-Effekt eine Strommessung eines jeweiligen entlang einer Stromschiene 33, 33a, 33b fließenden Stroms durchzuführen.

Daneben weist der Stromrichter 32 eine Leiterplatte 35 mit einer Steuerelektronik auf, wobei die Magnetfeldsensoren 34, 34a, 34b mit der Steuerelektronik der Leiterplatte 35 elektrisch verbunden sind. Die Leiterplatte 35 weist ferner zwei Positionierelemente 36 für eine jeweilige Magnetfeldkonzentrationsvorrichtung 30, 30a, 30b auf, die als Durchgangsöffnung ausgebildet sind. Durch die Positionierelemente 36 sind die dritten Positionierelemente 29, 29a der Magnetfeldkonzentrationsvorrichtungen 30, 30a, 30b durchgeführt, so dass deren Position bezüglich der Leiterplatte 35 festgelegt ist. Mittels Befestigungselementen 37 sind die Magnetfeldkonzentrationsvorrichtungen 30, 30a, 30b an der Leiterplatte 35 befestigt.

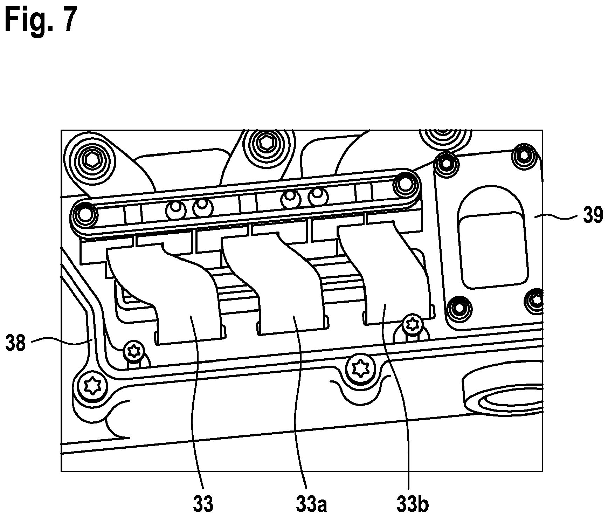

Fig. 7 ist eine teilweise perspektivische Darstellung des Stromrichters 32. Ersichtlich weisen die Stromschienen 33, 33a, 33b unmittelbar vor und hinter ihrer Durchführung durch die Durchführungsraum 31 (siehe Fig. 5) einen in einer Ebene gekrümmten Verlauf auf. Dieser gekrümmte Verlauf ist den beengten Platzverhältnissen im Stromrichter 32 geschuldet, bei dem die Stromschienen 33, 33a, 33b eng zwischen einem Gehäuserand 38 und einem Anschlusselement 39 geführt werden. Durch die Zweiteilung der Magnetfeldkonzentrationsvorrichtungen 30, 30a, 30b wird trotz dieser beengten Raumverhältnisse eine einfache Montierbarkeit an den Stromschienen 33, 33a, 33b ermöglicht.

## Patentansprüche

1. Stromrichter (32), umfassend
- wenigstens eine Magnetfeldkonzentrationsvorrichtung (30, 30a, 30b), umfassend zwei C-förmige Magnetfeldkonzentrationselemente (2, 3), die jeweils zwei Schenkel (4, 5) und einen die Schenkel (4, 5) verbindenden Steg (6) aufweisen und jeweils in einem Formteil (1, 1a) aufgenommen sind, wobei ein jeweiliges Formteil (1)
- eine Kavität (10) mit einem zum Aufnehmen des Stegs (6) ausgebildeten Stegaufnahmeraum (12), einem ersten Schenkelaufnahmeraum (13) und einem zweiten Schenkelaufnahmeraum (14), die jeweils zum Aufnehmen eines Schenkels (4, 5) ausgebildet sind,
- ein erstes Positionierelement (25), durch welches das andere Formteil (1a) spiegelsymmetrisch bezüglich des Formteils (1) positionierbar ist, und
- ein zweites Positionierelement (29), das außen an einer die Kavität (10) begrenzenden Mantelfläche (18) des Formteils (1) angeordnet ist,
aufweist und die Formteile (1, 1a) durch ihre ersten Positionierelemente (25, 25a, 26, 26a) derart zueinander angeordnet sind, dass innere und/oder stirnseitige Mantelflächen (19, 20, 21) der Formteile (1, 1a) einen Durchführungsraum (31) zumindest teilweise umschließen,
- wenigstens eine Stromschiene (33, 33a, 33b), die durch den Durchführungsraum (31) geführt ist,
- wenigstens einen Magnetfeldsensor (34, 34a, 34b), der zwischen freien Enden eines Schenkels (4) eines jeweiligen Magnetfeldkonzentrationselements (2, 3) einer Magnetfeldkonzentrationsvorrichtung (30, 30a, 30b) angeordnet ist, und
- eine Leiterplatte (35), die elektrisch leitend mit dem wenigstens einen Magnetfeldsensor (34, 34a, 34b) verbunden ist und ein Positionierelement (36) aufweist, durch welches das zweite Positionierelement (29, 29a) eines jeweiligen Formteils (1, 1a) an der Leiterplatte (35) anordenbar ist.

2. Stromrichter nach Anspruch 1, wobei der Stegaufnahmeraum (12) auf seiner den Schenkelaufnahmeräumen (14, 15) abgewandten Seite zum Einführen des Magnetfeldkonzentrationselements (2) geöffnet ist.

3. Stromrichter nach Anspruch 1 oder 2, wobei der erste Schenkelaufnahmeraum (13) auf seiner dem Stegaufnahmeraum (12) abgewandten Seite geöffnet ist.

4. Stromrichter nach einem der vorhergehenden Ansprüche, welches auf der dem zweiten Schenkelaufnahmeraum (15) zugewandten Seite des ersten Schenkelaufnahmeraums (14) einen Vorsprung (24) aufweist.

5. Stromrichter nach einem der vorhergehenden Ansprüche, wobei der zweite Schenkelaufnahmeraum (15) auf seiner dem Stegaufnahmeraum (12) abgewandten Seite geschlossen ist.

6. Stromrichter nach einem der vorhergehenden Ansprüche, wobei das Positionierelement (25) auf einer einen Schenkelabschnitt, insbesondere den zweiten Schenkelabschnitt (14), begrenzenden Grundfläche (17) des Formteils (1) angeordnet ist.

7. Stromrichter nach einem der vorhergehenden Ansprüche, wobei ein zum ersten Positionierelement (25) gegengleich ausgebildetes zweites Positionierelemente (26) vorgesehen ist.

8. Stromrichter nach Anspruch 6 und 7, wobei die Positionierelemente (25, 26) an gegenüberliegenden Grundflächen (11, 17) angeordnet sind.

9. Stromrichter nach einem der vorhergehenden Ansprüche, wobei ein Positionierelement einen Befestigungsmechanismus zum Befestigen des anderen Formteils und/oder das Formteil einen Befestigungsmechanismus zum Befestigen des Magnetfeldkonzentrationselements in der Kavität aufweist.

10. Stromrichter nach einem der vorhergehenden Ansprüche, wobei die Magnetfeldkonzentrationselemente (2, 3) in den Formteilen (1, 1a) und/oder die Positionierelemente (25, 25a, 26, 26a) miteinander verklebt sind.

11. Stromrichter nach einem der vorhergehenden Ansprüche, wobei eine Stromschiene (33, 33a, 33b) unmittelbar vor und/oder hinter ihrer Durchführung durch den Durchführungsraum (31) einen in einer Ebene gekrümmten Verlauf aufweist.

12. Stromrichter nach einem der vorhergehenden Ansprüche, wobei drei Magnetfeldkonzentrationsvorrichtungen (30, 30a, 30b) vorgesehen sind, durch deren Durchführungsraum (31) jeweils eine Stromschiene (33, 33a, 33b) geführt ist und denen jeweils ein Magnetfeldsensor (34, 34a, 34b) zugeordnet ist.

## Claims

1. Converter (32) comprising
- at least one magnetic field concentration device (30, 30a, 30b) comprising two C-shaped magnetic field concentration elements (2, 3) which have in each case two legs (4, 5) and one web (6) connecting the legs (4, 5) and are in each case received in a moulded part (1, 1a), wherein a respective moulded part (1) has
- a cavity (10) with a web receptacle space (12) which is configured to receive the web (6), a first leg receptacle space (13) and a second leg receptacle space (14) which are in each case configured to receive a leg (4, 5),
- a first positioning element (25) by way of which the other moulded part (1a) is able to be positioned so as to be mirror symmetrical in relation to the moulded part (1),
- a second positioning element (29) which is disposed externally on a shell face (18) of the moulded part (1) that delimits the cavity (10), and the moulded parts (1, 1a) by way of their first positioning elements (25, 25a, 26, 26a) are mutually disposed in such a manner that inner and/or frontal shell faces (19, 20, 21) of the moulded parts (1, 1a) at least partially enclose a conduit space (31),
- at least one busbar (33, 33a, 33b) which is led through the conduit space (31),
- at least one magnetic field sensor (34, 34a, 34b) which is disposed between free ends of a leg (4) of a respective magnetic field concentration element (2, 3) of a magnetic field concentration device (30, 30a, 30b), and
- a circuit board (35) which is connected in an electrically conducting manner to the at least one magnetic field sensor (34, 34a, 34b) and has a positioning element (36) by way of which the second positioning element (29, 29a) of a respective moulded part (1, 1a) is able to be disposed on the circuit board (35).

2. Converter according to Claim 1, wherein the web receptacle space (12) on the side thereof that faces away from the leg receptacle spaces (14, 15) is open for inserting the magnetic field concentration element (2).

3. Converter according to Claim 1 or 2, wherein the first leg receptacle space (13) on the side thereof that faces away from the web receptacle space (12) is open.

4. Converter according to one of the preceding claims, which on the side of the first leg receptacle space (14) that faces the second leg receptacle space (15) has a protrusion (24).

5. Converter according to one of the preceding claims, wherein the second leg receptacle space (15) on the side thereof that faces away from the web receptacle space (12) is closed.

6. Converter according to one of the preceding claims, wherein the positioning element (25) is disposed on a base area (17) of the moulded part (1) that delimits a leg portion, in particular the second leg portion (14).

7. Converter according to one of the preceding claims, wherein a second positioning element (26) configured to reciprocate the first positioning element (25) is provided.

8. Converter according to Claim 6 and 7, wherein the positioning elements (25, 26) are disposed on mutually opposite base areas (11, 17).

9. Converter according to one of the preceding claims, wherein a positioning element has a fastening mechanism for fastening the other moulded part and/or the moulded part has a fastening mechanism for fastening the magnetic field concentration element in the cavity.

10. Converter according to one of the preceding claims, wherein the magnetic field concentration elements (2, 3) in the moulded parts (1, 1a) and/or the positioning elements (25, 25a, 26, 26a) are adhesively bonded to one another.

11. Converter according to one of the preceding claims, wherein a busbar (33, 33a, 33b) directly in front of and/or behind the conduit thereof through the conduit space (31) has a profile that is curved in one plane.

12. Converter according to one of the preceding claims, wherein three magnetic field concentration devices (30, 30a, 30b) are provided, one busbar (33, 33a, 33b) being led in each case through the conduit space (31) of said three magnetic field concentration devices (30, 30a, 30b), and the latter being assigned in each case one magnetic field sensor (34, 34a, 34b).

## Revendications

1. Convertisseur statique (32) comprenant
- au moins un dispositif de concentration de champ magnétique (30, 30a, 30b), comprenant deux éléments de concentration de champ magnétique (2, 3) en forme de C qui comportent chacun deux branches (4, 5) et un dos (6) reliant les branches (4, 5) et qui sont logés chacun dans une pièce moulée (1, 1a),
une pièce moulée respective (1) comportant
- une cavité (10) pourvue d'un espace de réception de dos (12) conçu pour recevoir le dos (6), un premier espace de réception de branche (13) et un deuxième espace de réception de branche (14) qui sont chacun conçus pour recevoir une branche (4, 5)
- un premier élément de positionnement (25) qui permet de positionner l'autre pièce moulée (1a) en symétrie de miroir par rapport à la pièce moulée (1), et
- un deuxième élément de positionnement (29) qui est disposé à l'extérieur d'une surface d'enveloppe (18) de la pièce moulée (1) qui délimite la cavité (10)
et les pièces moulées (1, 1a) étant disposées les unes par rapport aux autres par leurs premiers éléments de positionnement (25, 25a, 26, 26a) de manière à ce que les surfaces d'enveloppe intérieures et/ou frontales (19, 20, 21) des pièces moulées (1, 1a) enferment au moins partiellement un espace de passage (31),
- au moins une barre conductrice (33, 33a, 33b) qui est guidée à travers l'espace de passage (31),
- au moins un capteur de champ magnétique (34, 34a, 34b) qui est disposé entre des extrémités libres d'une branche (4) d'un élément de concentration de champ magnétique respectif (2, 3) d'un dispositif de concentration de champ magnétique (30, 30a, 30b), et
- une carte de circuit imprimé (35) qui est reliée électriquement audit au moins un capteur de champ magnétique (34, 34a, 34b) et qui comporte un élément de positionnement (36) qui permet de disposer le deuxième élément de positionnement (29, 29a) d'une pièce moulée respective (1, 1a) sur la carte de circuit imprimé (35) .

2. Convertisseur statique selon la revendication 1, l'espace de réception de dos (12) étant ouvert sur son côté qui est opposé aux espaces de réception de branche (14, 15) afin d'insérer l'élément de concentration de champ magnétique (2).

3. Convertisseur statique selon la revendication 1 ou 2, le premier espace de réception de branche (13) étant ouvert sur son côté qui est opposé à l'espace de réception de branche (12).

4. Convertisseur statique selon l'une des revendications précédentes, qui comporte une saillie (24) du côté du premier espace de réception de branche (14) qui est dirigé vers le deuxième espace de réception de branche (15).

5. Convertisseur statique selon l'une des revendications précédentes, le deuxième espace de réception de branche (15) étant fermé sur son côté qui est opposé à l'espace de réception de dos (12).

6. Convertisseur statique selon l'une des revendications précédentes, l'élément de positionnement (25) étant disposé sur une surface de base (17) de la pièce moulée (1) qui délimite une portion de branche, en particulier la deuxième portion de branche (14).

7. Convertisseur statique selon l'une des revendications précédentes, un deuxième élément de positionnement (26) étant prévu dont la configuration est opposée à celle du premier élément de positionnement (25).

8. Convertisseur statique selon les revendications 6 et 7, les éléments de positionnement (25, 26) étant disposés sur des surfaces de base opposées (11, 17).

9. Convertisseur statique selon l'une des revendications précédentes, un élément de positionnement comportant un mécanisme de fixation destiné à fixer l'autre pièce moulée et/ou la pièce moulée comportant un mécanisme de fixation destiné à fixer l'élément de concentration de champ magnétique dans la cavité.

10. Convertisseur statique selon l'une des revendications précédentes, les éléments de concentration de champ magnétique (2, 3) dans les pièces moulées (1, 1a) et/ou les éléments de positionnement (25, 25a, 26, 26a) étant collés les uns aux autres.

11. Convertisseur statique selon l'une des revendications précédentes, une barre conductrice (33, 33a, 33b) présentant, immédiatement devant et/ou derrière son passage à travers l'espace de passage (31), une allure incurvée dans un plan.

12. Convertisseur statique selon l'une des revendications précédentes, trois dispositifs de concentration de champ magnétique (30, 30a, 30b) étant prévus qui comportent chacun un espace de passage (31) à travers lequel une barre conductrice (33, 33a, 33b) est guidée et à chacun desquels est associé un capteur de champ magnétique (34, 34a, 34b).
